# EUROPÄISCHE PATENTANMELDUNG

(11) **EP 1 134 889 A1**
(43) Veröffentlichungstag der Anmeldung: **19.09.2001**
(21) Anmeldenummer: 00105232.3
(22) Anmeldetag: 13.03.2000
(51) Int. Cl.: H03D 3/00

(54) **Anordnung und Verfahren zur Kompensation des Eingangs-Offsets eines Mischers**

(71) Anmelder: Infineon Technologies AG, 81669 München (DE)
(72) Erfinder: Asam, Michael, 85250 Wollomoos (DE)
(74) Vertreter: Hermann, Uwe, Dipl.-Ing.

(57) **Zusammenfassung**

Zur Kompensation des Offsets eines Mischers oder Modulators wird das Ausgangssignal (A) des Mischers (MI1) mit einem der beiden Eingangssignale (E2) des Mischers in einem Detektor verglichen. Der Detektor bestimmt das Vorzeichen (VZ) des Offsets des Mischers. Gemäß dem Verfahren der sukzessiven Approximation wird in einer Stelleinheit (SE) ein Kompensationswert gebildet, welcher dem Mischer (MI1) zugeführt wird. In einer vorteilhaften Ausführungsform der Erfindung wird zur Bestimmung des Offset-Vorzeichens (VZ) ein einfacher Phasendetektor (PD) verwendet. Die beschriebene indirekte Meßmethode arbeitet mit sehr hoher Genauigkeit, auch bei sehr kleinen Offsets. Offsets der dem Mischer (MI1) vorgeschalteten Schaltungen werden mit abgeglichen. Die Erfindung erübrigt einen manuellen beziehungsweise individuellen Abgleich von Gleichspannungsoffsets.

## Beschreibung

Die vorliegende Erfindung betrifft eine Anordnung und ein Verfahren zur Kompensation des Offsets eines Mischers.

Bei analogen integrierten Schaltungen, beispielsweise in Mobilfunk-Anwendungen, besteht häufig das Problem, daß in Mischern und Modulatoren durch interne oder externe Bauteiltoleranzen Gleichspannungsoffsets am Eingang der Mischer beziehungsweise Modulatoren auftreten. Dies hat zur Folge, daß ein am Eingang eingespeistes Trägersignal am Ausgang des Mischers beziehungsweise Modulators vorhanden ist. Dort ist das Trägersignal unerwünscht, da es unerwünschte Signale (Spurien) erzeugen bzw. bei Quadraturmodulatoren für digitale Modulationsarten, beispielsweise FSK, einen Versatz im IQ-Diagramm bewirken kann.

Gleichspannungsoffsets an Mischern oder Modulatoren können auch in Mischern oder Modulatoren vorgeschalteten Schaltungen entstehen. Bei Anwendung im Mobilfunk entstehen beträchtliche Offsets üblicherweise bereits im Basisband-Baustein, so daß sie in nachgeschalteten Quadraturmodulatoren des Sendepfades nachteilige Wirkung entfalten können. Beispielsweise in den D/A-Wandlern des Basisband-Bausteins können große Gleichspannungsoffsets entstehen.

Eine direkte Messung des Offsets, der üblicherweise sehr klein ist und nur wenige Millivolt betragen kann, beispielsweise eine Flash-Messung, ist für die praktische Umsetzung ungeeignet, da die einzusetzende Meßanordnung selbst offsetfrei sein müßte.

Eine bekannte Lösung zur Kompensation der beschriebenen Gleichspannungsoffsets besteht darin, das unerwünschte Trägersignal am Ausgang des betreffenden Mischers oder Modulators zu messen, und an den D/A-Wandlern des Basisband-Bausteins einen entgegengesetzten Offset zu programmieren, so daß der Gleichspannungsoffset am Mischer oder Modulator kompensiert ist.

Es ist allerdings aufwendig und kompliziert, die am Ausgang zu messende Amplitude eines Trägersignals in einen am Eingang anzulegenden Offset-Kompensationswert umzurechnen.

Bei Anwendung der Offsetkompensation in Sendepfaden im Mobilfunkbereich wird der unerwünschte Träger beispielsweise an der Antenne eines Mobilfunk-Gerätes gemessen. Es ist offensichtlich, daß diese individuelle Messung des Offsets einen großen meßtechnischen Aufwand mit sich bringt. Durch die aufzuwendende Zeit, die bereitzustellende Meßausrüstung und das erforderliche Personal entstehen beträchtliche Kosten. Weitere Nachteile dieser Standardlösung sind dadurch gegeben, daß der programmierte, entgegengesetzte Offset in den D/A-Wandlern den Aussteuerbereich derselben verringert, die Auflösung der Wandler verringert, sowie das Rauschen erhöht.

Eine weitere, bekannte Lösung, störende Trägersignale am Ausgang von Mischern beziehungsweise Modulatoren zu verringern, ist der Einbau zusätzlicher Filter. Für die Integration zusätzlicher Filter ist jedoch Chipfläche sowie die Bereitstellung von Versorgungs-Energie erforderlich. Außerdem sind mit der Integration zusätzlicher Filter zusätzliche Kosten verbunden. Die Anordnung der zusätzlichen Filter in externen Komponenten macht zusätzliche Pins an den Halbleiter-Bauelementen erforderlich. Bei Quadraturmodulatoren ist der Einsatz zusätzlicher Filter nicht möglich, da die störende Trägerfrequenz am Ausgang im Nutzband des Modulators liegt.

Eine weitere, bekannte Möglichkeit, den Offset an Mischern oder Modulatoren zu verringern, ist dadurch gegeben, Fehlanpassungen auf dem Halbleiter-Baustein möglichst zu verringern beziehungsweise zu vermeiden. Hierfür sind jedoch großflächige Bauelemente, wie beispielsweise Widerstände oder parallele Transistoren erforderlich, wodurch sich der Flächenbedarf der gesamten Schaltung in nachteilhafter Weise vergrößert.

Im Mobilfunkbereich sind die Abmessungen sowie das Gewicht von Schaltungen neben den Kostenaspekten wichtige Entwicklungsziele.

In der Druckschrift DE 19743272 C1 ist eine Anordnung und ein Verfahren zur Kompensation des Offsets eines Mischers angegeben. Die Schaltung weist einen ersten integrierten Schaltkreis auf, mit einem Mischer und einer Stelleinheit zur Erzeugung eines Offsetkompensationswertes, sowie einen Bus, an den ein zweiter integrierter Schaltkreis angeschlossen ist, in dem der Offset erfaßt wird. Diese Schaltung ist beispielsweise zur Anwendung in einem Empfangspfad im Mobilfunk geeignet. Die Messung des Offsets ist bei der beschriebenen Anordnung aufwendig, außerdem müssen an diese Offset-Erfassung hohe Genauigkeitsanforderungen gestellt werden. Zur Rückführung des Offsets auf die Stelleinheit ist ein Bus mit drei Leitern vorgesehen.

Aufgabe der vorliegenden Erfindung ist es, eine Anordnung und ein Verfahren zur Kompensation des Offsets eines Mischers anzugeben, welche mit geringem Aufwand und geringem Bedarf an Chipfläche realisierbar sind.

Erfindungsgemäß wird diese Aufgabe bezüglich der Anordnung gelöst von einer Anordnung zur Kompensation des Offsets eines Mischers, mit einem ersten Mischer mit einem ersten Eingang, einem zweiten Eingang und einem Ausgang; einem Detektor, der an den Ausgang des ersten Mischers angeschlossen ist, und an dessen Ausgang das Vorzeichen des Offsets anliegt; einer Stelleinheit zur Erzeugung eines Offsetkompensationswertes, der das Vorzeichen des Offsets zuführbar ist, und die mit dem ersten Mischer gekoppelt ist; und einer Steuereinheit, die mit der Stelleinheit verbunden ist, zur Steuerung der Erzeugnung verschiedener Offsetkompensationswerte.

Bezüglich des Verfahrens wird die Aufgabe gelöst mit einem Verfahren zur Kompensation des Offsets eines Mischers mit folgenden Verfahrensschritten: Bestimmen des Vorzeichens eines Gleichspannungsoffsets eines ersten Mischers durch Vergleich eines an einem Eingang eines ersten Mischers anliegenden Signals mit einem an einem Ausgang des ersten Mischers ableitbaren Signals; schrittweises Setzen von Bits in einer Stelleinheit, beginnend bei einem höchstwertigen Bit; Bilden eines Offset-Kompensationswertes in der Stelleinheit und Führen des Offset-Kompensationswertes an den ersten Mischer; Rücknahme des zuletzt gesetzten Bits, falls durch Setzen desselben ein Wechsel des Vorzeichens erfolgt; Stehenlassen des zuletzt gesetzten Bits, falls durch Setzen desselben kein Wechsel des Vorzeichens erfolgt.

In dem Detektor, welcher an den ersten Mischer angeschlossen ist, wird nicht der Offset selbst erfaßt, sondern lediglich das Vorzeichen des Offsets. Dieses Vorzeichen des Offsets ist einer Stelleinheit zuführbar. Am Ausgang der Stelleinheit steht ein Offsetkompensationswert an, welcher dem ersten Mischer zuführbar ist. Der in der Stelleinheit generierte Offsetkompensationswert wird, gemäß dem bekannten Verfahren der sukzessiven Approximation, schrittweise erhöht. Ändert sich dabei das Vorzeichen des Offsets, welches mit dem Detektor erfaßbar ist, so ist der Offset überkompensiert. Der Offsetkompensationswert muß in diesem Fall reduziert werden.

Die Ablaufsteuerung des Approximationsverfahrens zur Kompensation erfolgt mittels einer Steuereinheit, welche an die Stelleinheit angeschlossen ist.

Da bei der vorliegenden Erfindung nicht der Offset selbst erfaßt werden muß, sondern lediglich das Vorzeichen desselben, ist der Aufbau des Detektors sehr einfach. Die Anforderungen an die Anpassung der zusätzlichen Schaltung sowie an die Genauigkeit des Detektors sind gering, deshalb können sie sehr platzsparend realisiert werden. Die Messung lediglich des Vorzeichens erlaubt einen Abgleich mit sehr hoher Genauigkeit, auch bei sehr kleinen Offsets. Da Fehlanpassungen bei Mischern und Modulatoren nunmehr gut abgleichbar sind, kann die Baugröße der Mischer beziehungsweise Modulatoren reduziert werden. Ein Übersprechen, welches entweder in internen Leitungen oder durch das Gehäuse hervorgerufen wird, wird von der beschriebenen Schaltung mit abgeglichen. Gegenüber dem Eingangs beschriebenen Abgleich des Geräts durch Einstellen eines Offsets an den D/A-Wandlern des Basisband-Bausteins, welches nur einmal während der Herstellung durchgeführt wird, kann der beschriebene Abgleich in regelmäßigen Abständen oder bei Bedarf durchgeführt werden, beispielsweise bei dem Einschaltvorgang des Gerätes. Hierdurch ist es möglich, auch zeitlich veränderliche Parameter beziehungsweise deren Wirkungen, welche sich in einem Offset manifestieren, zu kompensieren. Beispielsweise kann der zu kompensierende Offset von der Alterung des Gerätes, von der Temperatur, oder von der Batteriespannung abhängen.

Bei Anordnung der beschriebenen Schaltung in einem Sendepfad bei Mobilfunkanwendungen werden Offsets mit abgeglichen, welche in den dem Mischer oder Modulator vorgeschalteten Schaltungen entstehen. Beispielsweise werden die Offsets der D/A-Wandler des Basisband-Bausteins mit abgeglichen, so daß bei diesen Wandlern die volle Bitzahl, und damit der volle Aussteuerbereich zur Verfügung steht. Die guten Rauscheigenschaften der Wandler bleiben hierdurch erhalten. Da die Offset-Kompensation nunmehr automatisch abläuft, muß kein individueller beziehungsweise manueller Abgleich des Offsets mehr durchgeführt werden. Hierdurch sind Einsparungen bezüglich Meß-Ausrüstung, Personalaufwand, und Zeit bei der Herstellung möglich. Die beschriebene Schaltung erübrigt außerdem den Einbau zusätzlicher Filter zum Herausfiltern unerwünschter Signale, welche durch Offsets beziehungsweise Trägerübersprechen entstehen können.

In einer vorteilhaften Ausführungsform der vorliegenden Erfindung ist der Detektor ein Phasendetektor. Ist das Trägersignal mit einem positiven Offset behaftet, so ist das Trägersignal am Ausgang in Phase mit demjenigen am Eingang. Ist der Offset negativ, so hat der Träger am Ausgang eine um 180° verschobene Phase gegenüber dem Träger am Eingang. Aus der Phasenlage der Signale zueinander kann eindeutig auf das Vorzeichen des Offsets rückgeschlossen werden. Der Phasendetektor kann als einfacher Mischer mit nachgeschaltetem Tiefpaß-filter ausgeführt sein. Das am Ausgang des Detektors anliegende Gleichspannungs-Signal hat ein Vorzeichen, welches mit dem Vorzeichen des zu kompensierenden Offsets identisch ist.

In einer weiteren vorteilhaften Ausführungsform der Erfindung kann der Mischer des Phasendetektors als einfache Gilbertzelle ausgeführt sein.

In einer vorteilhaften Ausführungsform der Erfindung weist die Stelleinheit zur Erzeugung des Offsetkompensationswertes ein Register sowie einen D/A-Wandler auf.

Weitere Ausgestaltungen der Erfindung sind in den Unteransprüchen angegeben.

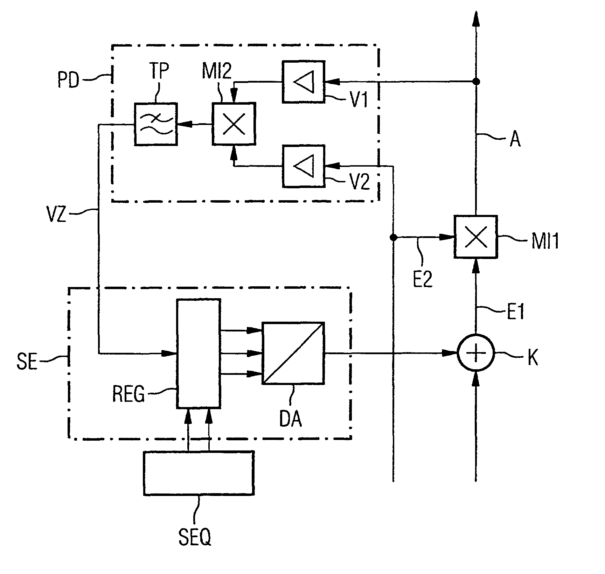

Die Erfindung wird nun an einem Ausführungsbeispiel anhand der Figur näher erläutert. Es zeigt:
die Figur eine Ausführungsform der Erfindung anhand eines Blockschaltbildes.

Die Figur zeigt einen Mischer MI1 mit zwei Eingängen E1, E2 und mit einem Ausgang A. An den Ausgang A ist ein Phasendetektor PD angeschlossen, welcher ebenfalls an den zweiten Eingang E2 des Mischers MI1 angeschlossen ist. Der Phasendetektor ist an eine Stelleinheit SE angeschlossen, welche wiederum über einen Addierknoten K an den ersten Eingang E1 des Mischers MI1 angeschlossen ist. Der Phasendetektor PD weist zwei Verstärker V1, V2 auf, welchen die Eingangssignale des Phasendetektors zuführbar sind. Der erste Verstärker V1 ist mit dem Ausgang A des ersten Mischers MI1 verbunden. Der Verstärker V2 ist eingangsseitig mit dem zweiten Eingang E2 des ersten Mischers MI1 verbunden. Der erste Verstärker V1 und der zweite Verstärker V2 sind ausgangsseitig an zwei Eingänge eines zweiten Mischers MI2 angeschlossen, dessen Ausgang mit dem Eingang eines Tiefpaß-Filters TP verbunden ist. Der Ausgang des Tiefpaß-Filters TP ist an den Eingang eines Registers REG in der Stelleinheit SE angeschlossen. Das Register REG ist mit einer Vielzahl von Leitungen an einen D/A-Wandler DA angeschlossen. Der Ausgang des D/A-Wandlers DA ist mit einem Eingang eines Addierknotens verbunden, dessen Ausgang mit dem Eingang E1 des ersten Mischers verbunden ist. Ein Sequenzer SEQ ist an das Register REG der Stelleinheit SE angeschlossen.

Der Mischer MI1 kann einen zu kompensierenden, unerwünschten Gleichspannungsoffset aufweisen. Wenn der erste Mischer MI1 einen eingangsseitigen Gleichspannungsoffset aufweist, so führt das dazu, daß ein am zweiten Eingang E2 beispielsweise anlegbares Trägersignal am Ausgang A des ersten Mischers MI1 detektierbar ist. Der eingangsseitige Gleichspannungsoffset des ersten Mischers MI1, welcher die an den Eingängen E1, E2 anliegenden Signale multipliziert, kann positiv oder negativ sein. Der Phasendetektor PD vergleicht das Ausgangssignal des ersten Mischers MI1 mit dem am zweiten Eingang des ersten Mischers MI1 zuführbaren Signal. Je nachdem, ob der eingangsseitige Gleichspannungsoffset am ersten Mischer MI1 ein positives oder ein negatives Vorzeichen aufweist, liegt am Ausgang des Phasendetektors PD ein Gleichspannungssignal mit positivem oder negativem Vorzeichen VZ an. Der Phasendetektor PD detektiert das Vorzeichen des Offsets derart, daß er die Phasenlagen des am Ausgang A des ersten Mischers MI1 anliegenden Signals mit dem am zweiten Eingang E2 des ersten Mischers MI1 anliegenden Signals vergleicht. In Abhängigkeit des Vorzeichens des Offsets am ersten Mischer MI1 liegt zwischen den dem ersten und zweiten Verstärker V1, V2 zuführbaren Signalen entweder eine Phasendifferenz von 0° oder eine Phasendifferenz von 180° vor. Der zweite Mischer MI2 kann beispielsweise als einfache Gilbertzelle zur Multiplikation zweier Signale ausgeführt sein. Am Ausgang des Tiefpaßfilters TP ist ein Gleichspannungspegel abgreifbar, dessen Vorzeichen dasselbe ist wie das des zu kompensierenden Offsets. Die Stelleinheit SE generiert am Ausgang des D/A-Wandlers einen Kompensationswert zur Kompensation des Offsets des ersten Mischers MI1 unter Benutzung des Prinzips der sukzessiven Approximation, auch Wägeverfahren genannt. Dabei wird zu Beginn die zu generierende Zahl auf 0 gesetzt, und anschließend wird vom höchstwertigen Bit (MSB, Most Significant Bit) bis zum niedrigsten Bit (LSB, Least Significant Bit) jedes Bit einzeln nacheinander auf 1 gesetzt und zurückgenommen, wenn überkompensiert wurde, das heißt, wenn das Vorzeichen VZ beim Setzen eines neuen Bit einen Vorzeichenwechsel hat. Die jeweils aktuelle Zahl, welche die Bits vom höchstwertigen bis zum niederwertigen umfaßt, wird im Register REG gespeichert. Den beschriebenen zeitlichen Ablauf steuert ein Sequenzer SEQ. Die beiden Verstärker V1, V2 bewirken, daß selbst geringe Offsets detektierbar und kompensierbar sind. Liegt am zweiten Eingang des ersten Mischers MI1 beispielsweise ein Trägersignal an, und ist der erste Eingang E1 des ersten Mischers MI1 signalfrei (balanced), aber mit einem Gleichspannungs-Offset behaftet, so liegt am Ausgang A des ersten Mischers MI1 ebenfalls das Trägersignal an. Ist der Offset am ersten Eingang E1 negativ, so hat das Trägersignal am Ausgang A eine um 180° verschobene Phase gegenüber dem Trägersignal am zweiten Eingang E2, ist der Offset am ersten Eingang E1 positiv, so beträgt die Phasenverschiebung zwischen zweitem Eingang E2 und Ausgang A 0°. Die Anordnung des Phasendetektors führt dazu, daß geringe Phasenverschiebungen der an den beiden Verstärkern V1, V2 anlegbaren Signale keine Auswirkungen am Ausgang des Phasendetektors PD haben.

Die Anforderungen bezüglich Matching, Rauschen etc., welche an den Vorzeichendetektor PD gestellt werden müssen, sind gering. Daher kann der Phasendetektor PD mit verhältnismäßig geringem Aufwand und auf kleiner Chipfläche realisiert werden.

Die beschriebene, indirekte Offset-Messung durch Messung am Ausgang des ersten Mischers MI1 kompensiert auch Trägerübersprechen, welches beispielsweise durch Leitungs- oder Gehäuseübersprechen verursacht sein kann.

Die beschriebene Anordnung ermöglicht es, auch Gleichspannungsoffsets zu kompensieren, welche schaltungstechnisch vor dem ersten Mischer MI1 entstehen, beispielsweise in den D/A-Wandlern eines dem Mischer vorgeschalteten Basisband-Bausteins bei Anwendung im Mobilfunk.

Der zu kompensierende Offset kann von Umgebungsparametern, wie beispielsweise Temperatur oder Batteriespannung, aber auch von Alterungsvorgängen abhängen. Die beschriebene Schaltungsanordnung ermöglicht einen automatischen Abgleich beziehungsweise eine automatische Offset-Kompensation, beispielsweise beim Einschalten des Geräts, in dem sich die Schaltung befindet, so daß beispielsweise ein Temperaturdrift mitkompensiert werden kann. Der üblicherweise bei der Herstellung durchgeführte, einmalige Abgleich leistet dies nicht.

Die Methode der sukzessiven Approximation garantiert eine sehr hohe Genauigkeit der Kompensation, auch bei sehr kleinen Offset-Werten.

In Abwandlungen des beschriebenen Ausführungsbeispiels eignet sich die Kompensationsanordnung auch für Modulatoren, welche anstelle des ersten Mischers MI1 treten können.

Der Offset-Kompensationswert selbst kann beispielsweise durch nicht eingezeichnete, schaltbare Stromquellen oder Spannungsquellen realisiert sein, welche an den D/A-Wandler DA anschließbar sind.

Anwendung kann die beschriebene Schaltungsanordnung beispielsweise in Single-Chip Transceivern von GSM-Mobilfunkanwendungen finden. Dort ist ein dem Basisband-Baustein nachgeschalteter Quadraturmodulator vorgesehen, dessen DC-Offsets somit kompensierbar sind. Da in Single-Chip-Transceivern üblicherweise bereits Sequenzer zur Steuerung angeordnet sind, ist zur Durchführung des beschriebenen Verfahrens lediglich die Integration eines Registers sowie eines Vorzeichendetektors erforderlich.

## Patentansprüche

1. Anordnung zur Kompensation des Offsets eines Mischers, mit
- einem ersten Mischer (MI1) mit einem ersten Eingang (E1), einem zweiten Eingang (E2) und einem Ausgang (A),
- einem Detektor (PD), der an den Ausgang (A) des ersten Mischers (MI1) angeschlossen ist und an dessen Ausgang das Vorzeichen (VZ) des Offsets anliegt,
- einer Stelleinheit (SE) zur Erzeugung eines Offsetkompensationswertes, der das Vorzeichen (VZ) des Offsets zuführbar ist, und die mit dem ersten Mischer (MI1) gekoppelt ist und
- einer Steuereinheit (SEQ), welche mit der Stelleinheit (SE) verbunden ist, zur Steuerung der Erzeugung verschiedener Offsetkompensationswerte.

2. Anordnung nach Anspruch 1,
**dadurch gekennzeichnet**, daß
der Detektor (PD) ein Phasendetektor ist.

3. Anordnung nach Anspruch 2,
**dadurch gekennzeichnet**, daß
der Phasendetektor (PD) einen ersten und einen zweiten Verstärker (V1, V2) aufweist, deren Ausgänge mit einem zweiten Mischer (MI2) verbunden sind, dem ein Tiefpaß-Filter (TP) nachgeschaltet ist.

4. Anordnung nach Anspruch 3,
**dadurch gekennzeichnet**, daß
der zweite Mischer (MI2) ein Gilbert-Multiplizierer ist.

5. Anordnung nach einem der Ansprüche 1 bis 4,
**dadurch gekennzeichnet**, daß
die Stelleinheit (SE) ein Register (REG) und einen daran angeschlossenen D/A-Wandler (DA) aufweist.

6. Anordnung nach Anspruch 5,
**dadurch gekennzeichnet**, daß
die Stelleinheit (SE) schaltbare Stromquellen oder Spannungsquellen aufweist.

7. Verfahren zur Kompensation des Offsets eines Mischers mit folgenden Verfahrensschritten:
- Bestimmen des Vorzeichens (VZ) eines Gleichspannungsoffsets eines ersten Mischers (MI1) durch Vergleich eines an einem Eingang (E2) eines ersten Mischers (MI1) anliegenden Signals mit einem an einem Ausgang (A) des ersten Mischers (MI1) ableitbaren Signals,
- Schrittweises Setzen von Bits in einer Stelleinheit (SE), beginnend bei einem höchstwertigen Bit,
- Bilden eines Offset-Kompensationswertes in der Stelleinheit (SE) und Führen des Offset-Kompensationswertes an den ersten Mischer (MI1),
- Rücknahme des zuletzt gesetzten Bits, falls durch Setzen desselben ein Wechsel des Vorzeichens (VZ) erfolgt,
- Stehenlassen des zuletzt gesetzten Bits, falls durch Setzen desselben kein Wechsel des Vorzeichens (VZ) erfolgt.

8. Verfahren nach Anspruch 7,
**dadurch gekennzeichnet**, daß
das Offset-Vorzeichen (VZ) durch Vergleich der Phasenlagen des am Ausgang (A) des ersten Mischers (MI1) ableitbaren Signals und des an einem Eingang (E2) des ersten Mischers (MI1) anliegenden Signals.

9. Verfahren nach Anspruch 8,
**dadurch gekennzeichnet, daß**
das Vorzeichen (VZ) des Offsets des ersten Mischers (MI1) gleich 1 ist, wenn die Phasen der Signale eine Differenz von 0° aufweisen, und daß das Vorzeichen des Offsets -1 beträgt, wenn die Differenz der Phasen der Signale 180° beträgt.
